(19) Europäisches Patentamt / European Patent Office / Office européen des brevets

(11) **EP 1 631 984 B1**

(12) **FASCICULE DE BREVET EUROPEEN**

(45) Date de publication et mention de la délivrance du brevet:
**23.08.2017 Bulletin 2017/34**

(21) Numéro de dépôt: **04767238.1**

(22) Date de dépôt: **03.06.2004**

(51) Int Cl.:
*H01L 21/762* *(2006.01)*    *H01L 21/20* *(2006.01)*

(86) Numéro de dépôt international:
**PCT/FR2004/001369**

(87) Numéro de publication internationale:
**WO 2005/004233 (13.01.2005 Gazette 2005/02)**

(54) **PROCÉDÉ D'OBTENTION D'UNE STRUCTURE COMPRENANT UN SUBSTRAT SUPPORT ET UNE COUCHE ULTRAMINCE**

VERFAHREN ZUR HERSTELLUNG EINES STRUKTUR AUF EINEM TRÄGERSUBSTRAT MIT EINER ULTRADÜNNEN SCHICHT

METHOD FOR OBTAINING A STRUCTURE HAVING A SUPPORTING SUBSTRATE AND AN ULTRA-THIN LAYER

(84) Etats contractants désignés:
**AT BE BG CH CY CZ DE DK EE ES FI FR GB GR HU IE IT LI LU MC NL PL PT RO SE SI SK TR**

(30) Priorité: **06.06.2003 FR 0306843**

(43) Date de publication de la demande:
**08.03.2006 Bulletin 2006/10**

(73) Titulaires:
• **Soitec**
  **38190 Bernin (FR)**
• **Commissariat à l'Énergie Atomique et aux Énergies Alternatives**
  **75015 Paris (FR)**

(72) Inventeurs:
• **AULNETTE, Cécile**
  **F-38000 Grenoble (FR)**
• **BATAILLOU, Benoît**
  **B-1320 hamme-Mille (Beauvechain) (BE)**
• **GHYSELEN, Bruno**
  **F-38170 Seyssinet (FR)**
• **MORICEAU, Hubert**
  **F-38120 Saint Egreve (FR)**

(74) Mandataire: **Regimbeau**
  **Parc d'affaires Cap Nord A**
  **2, allée Marie Berhaut**
  **CS 71104**
  **35011 Rennes Cedex (FR)**

(56) Documents cités:
  **WO-A-00/48278        WO-A-02/43112**
  **US-B1- 6 335 258**

• **BRUEL M: "Silicon on insulator material technology" ELECTRONICS LETTERS, IEE STEVENAGE, GB, vol. 31, no. 14, 6 juillet 1995 (1995-07-06), pages 1201-1202, XP006003062 ISSN: 0013-5194**

**Description**

La présente invention concerne un procédé d'obtention d'une structure comprenant au moins un substrat support et une couche ultramince d'un matériau notamment semi-conducteur, et éventuellement une couche intercalaire insérée entre les deux.

Au cours de la fabrication de substrats composites, notamment pour des applications dans les domaines de l'optique, l'électronique ou l'optoélectronique, on utilise des procédés de transfert de couche qui permettent de transférer une couche issue d'un substrat source, sur un substrat support.

L'un de ces procédés de transfert de couche consiste à implanter des espèces atomiques sous la surface d'un substrat source, de façon à y créer une zone de fragilisation qui délimite une couche mince. On procède ensuite à la mise en contact intime de la face libre de cette couche mince avec le substrat support, puis au détachement de ladite couche mince, du reste du substrat source et à son transfert sur le substrat support.

Ce type de procédé est connu sous la marque déposée "Smart Cut".

L'évolution actuelle de la technologie consiste à essayer de transférer sur un support, des couches de plus en plus minces, de façon à obtenir des substrats composites à partir desquels on pourra fabriquer des composants électroniques dont la vitesse de fonctionnement sera encore plus rapide que celles des composants existants.

Sur ce sujet, on peut se reporter par exemple à l'article de Aaron Mand, "Value-Added Wafers Push Chips Ahead", Semiconductor International, novembre 2002.

Toutefois, les tentatives effectuées jusqu'à présent ont montré que lorsque la couche mince à transférer est très mince, c'est-à-dire inférieure à environ 100 nm, elle présentait des défauts qui n'apparaissent pas dans le cas du transfert d'une couche plus épaisse. Ainsi, elle ne supporte pas les traitements thermiques ultérieurs effectués soit pour renforcer son interface de collage avec le support, soit pour la détacher du substrat source. En effet, de tels traitements thermiques ont pour conséquence d'augmenter la pression régnant dans les microbulles gazeuses présentes au niveau de la zone de fragilisation et d'entraîner leur dégazage. La couche très mince transférée présente alors de nombreux défauts, tels que des cloques ou une délamination partielle.

Par ailleurs, il semble que lorsque l'on transfert une couche très mince sur un substrat support, la qualité du collage obtenu est beaucoup plus sensible à la présence de particules ou d'hydrocarbure à la surface des couches à mettre en contact que lorsque l'on transfert une couche plus épaisse.

De même, lorsqu'il existe une couche intercalaire entre la couche mince à transférer et le substrat support, on a constaté que la couche mince transférée présente d'autant plus de défauts que cette couche intercalaire est mince.

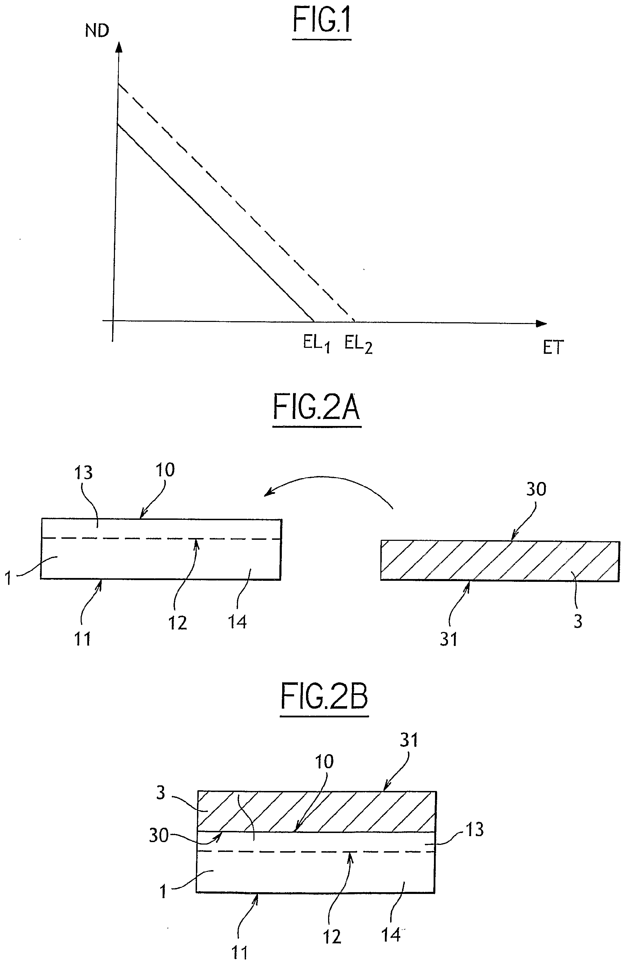

La figure 1 jointe est un graphique représentant de façon théorique, l'épaisseur totale **ET** de la couche transférée, c'est-à-dire la somme des épaisseurs de la couche mince et de la couche intercalaire, en fonction du nombre de défauts **ND** sur la structure finie, et ce pour une épaisseur donnée de couche intercalaire.

Comme on peut le voir sur cette figure qui est un schéma de principe, pour une épaisseur donnée de couche intercalaire (droite en trait plein), on aboutit à une épaisseur limite $EL_1$ de la couche mince transférée en dessous de laquelle on ne peut descendre; sauf à obtenir un transfert de couche défectueux. Pour une épaisseur plus faible encore de la couche intercalaire (droite en pointillés), l'épaisseur limite $EL_2$ de la couche mince transférée est encore plus importante.

Dans le cas particulier des substrats SOI ("SOI" étant l'acronyme de l'expression anglo-saxonne "Silicon On Insulator" qui signifie "silicium sur isolant") on réalise une implantation d'espèces atomiques, généralement des ions hydrogène, à la surface d'un substrat en silicium dont la surface extérieure est oxydée, puis on colle sur l'ensemble un second substrat en silicium. Après détachement puis recuit, on obtient le substrat SOI comprenant une couche de silicium massive recouverte d'une couche d'oxyde ($SiO_2$) et d'une couche de silicium transférées, (voir l'article "Silicon on insulator material technology" de M.Bruel, Electron Letter, 31, 1201 (1995).

En dessous d'une certaine épaisseur de la couche d'oxyde enterrée, on constate que la couche de silicium transférée présente des défauts, ces derniers étant d'autant plus marqués que l'on utilise en outre un traitement thermique à haute température. A ce sujet, on peut se référer à l'article de Q.-y. Tong, G. Cha, R. Gafiteau et U. Gösele, "Low temperature wafer direct bonding", J. Microelectromech Syst., 3, 29, (1994).

Une explication possible concernant l'apparition de ces défauts est l'existence d'un dégazage au niveau de l'interface de collage entre la couche d'oxyde de silicium et le second substrat en silicium.

Lors du traitement thermique de recuit, dit "traitement de stabilisation", intervenant après l'étape de détachement, il se forme un gaz au niveau de l'interface de collage. Dans le cas d'un substrat SOI épais, l'épaisseur de la couche transférée est importante et joue le rôle de raidisseur. Par ailleurs, on suppose que la couche d'oxyde également épaisse joue un rôle d'éponge en absorbant les gaz dégagés au niveau de l'interface de collage.

Dans le cas d'un substrat SOI fin dans lequel la couche transférée et/ou la couche d'oxyde sont fines, les phénomènes précités d'absorption et d'effet raidisseur n'ont pas lieu et le dégazage conduit à un mauvais scellement de l'interface de collage.

Une autre explication possible est que dans les substrats SOI fins, l'hydrogène est implanté à faible profondeur par rapport à l'interface de collage. La couche transférée est donc gorgée d'hydrogène qui a tendance à migrer par diffusion en direction de l'interface de collage.

Les substrats SOI obtenus par les techniques actuelles comprennent des couches d'oxyde enterré (SiO$_2$) et de silicium superficiel dont les épaisseurs varient de 100 nm à 1,5 $\mu$m. Jusqu'à ce jour, il a été difficile d'obtenir des substrats SOI de bonne qualité dans lesquels ces deux couches sont d'une épaisseur moindre.

Les tentatives effectuées jusqu'à présent dans ce sens ont toutes eu pour objet de renforcer le collage entre les couches, sans pour autant permettre l'obtention de résultats satisfaisants.

On notera enfin que l'on connaît d'après le document WO-00/48278, un procédé de formation d'une couche de silicium à usage optique comprenant des étapes de transfert de couche et d'amincissement. Ce procédé vise à obtenir une couche de silicium à usage optique, d'une épaisseur déterminée dite "optique" égale à

$$\frac{\lambda}{4n_s}$$ où $\lambda$ est la longueur d'onde de la lumière produite

ou reçue et $n_s$ l'indice de réfraction du silicium.

Toutefois ce procédé n'a pas pour but d'obtenir une couche ultra mince et n'évoque en conséquence absolument pas les problèmes d'apparition de cloques ou de défauts lors du report d'une couche ultra mince sur un support.

Enfin, ce document ne suggère absolument pas d'utiliser l'étape intermédiaire du report d'une couche dont l'épaisseur est notablement plus grande que celle de la couche ultramince à obtenir.

La présente invention a pour but de résoudre les inconvénients précités et d'offrir un procédé permettant de reporter sur un substrat support, une couche transférée et éventuellement une couche intercalaire, dont les épaisseurs sont très faibles, c'est à dire inférieures à environ 50 nanomètres (50 nm), voire même inférieures à 20 nm. On parle alors de couches "ultra minces".

L'invention s'applique notamment à la fabrication de tous les substrats présentant un empilement de couches dont certaines sont sensibles au dégazage.

A cet effet, l'invention concerne un procédé d'obtention d'une structure comprenant au moins un substrat support et une couche ultra mince issue d'un substrat source notamment en matériau semi-conducteur, pour des applications dans les domaines de l'électronique, l'optoélectronique ou l'optique, ce procédé comprenant les étapes consistant à :

- a) coller par adhésion moléculaire un substrat support sur l'une des faces, dite "face avant", d'un substrat source qui présente intérieurement une zone de fragilisation délimitant avec ladite face avant, une couche utile dite "couche à transférer" dont l'épaisseur est notablement plus grande que celle de ladite couche ultramince,
- b) détacher ledit substrat support et ladite couche utile à transférer, du reste du substrat source, le long de ladite zone de fragilisation, de façon à obtenir une structure intermédiaire comprenant au moins ladite couche utile transférée et ledit substrat support,
- c) procéder à l'amincissement de ladite couche utile transférée jusqu'à obtenir ladite couche ultra mince, ce procédé étant caractérisé en ce que la couche utile à transférer de la structure intermédiaire présente une épaisseur au moins trois fois supérieure ou égale à celle de ladite couche ultramince obtenue à l'issue de l'étape c) d'amincissement et en ce que l'épaisseur de ladite couche ultramince est inférieure ou égale à 100 nanomètres et en ce que l'épaisseur de la couche utile à transférer de la structure intermédiaire est supérieure ou égale à 300 nanomètres.

Selon d'autres caractéristiques avantageuses et non limitatives de l'invention, prises seules ou en combinaison :

- l'étape a) de collage par adhésion moléculaire du substrat support se fait sur une couche intercalaire présente sur la face avant dudit substrat source ;
- l'épaisseur de la couche ultra mince est inférieure ou égale à 50 nanomètres ;
- l'épaisseur de ladite couche intercalaire est inférieure ou égale à 50 nanomètres ;
- ladite couche intercalaire est une couche de matériau isolant ;
- la couche intercalaire est une couche d'un matériau choisi parmi l'oxyde de silicium, le nitrure de silicium, les matériaux isolants à forte permittivité, le diamant et les combinaisons de ces matériaux ;
- l'amincissement est réalisé par au moins l'une des techniques suivantes parmi le polissage mécanico-chimique, le recuit sous une atmosphère contenant de l'hydrogène, de l'argon ou un mélange des deux, l'oxydation sacrificielle et la gravure chimique ;
- on procède à un traitement de recuit thermique après l'étape a) de collage et avant l'étape c) d'amincissement ;
- le traitement de recuit thermique est effectué pendant l'étape b) de détachement ;
- le traitement de recuit thermique est effectué avant l'étape b) de détachement ;
- la zone de fragilisation est obtenue par implantation d'espèces atomiques ;
- la zone de fragilisation est une couche poreuse ;
- le détachement de l'étape b) comprend l'application de contraintes mécaniques et/ou thermiques ;
- la couche utile transférée est une couche comportant des motifs suspendus ;
- le substrat source est réalisé dans un matériau choisi parmi le silicium, le carbure de silicium, le germanium, le silicium germanium, les composés IV-IV et les composés III-V ou une combinaison de ces matériaux ;

- le substrat support est réalisé dans un matériau choisi parmi le silicium, le carbure de silicium, le germanium, le silicium germanium, les composés IV-IV et les composés III-V ou une combinaison de ces matériaux.

D'autres caractéristiques et avantages de l'invention apparaîtront à la lecture de la description qui va maintenant en être faite en référence aux dessins annexés qui en représentent, à titre indicatif mais non limitatif, des modes de réalisation possibles.

Sur ces dessins :

- la figure 1 est un graphique représentant l'épaisseur totale **ET** d'une couche transférée (couche mince et couche intercalaire), en fonction du nombre de défauts **ND** observés sur la structure finie, pour deux épaisseurs différentes de ladite couche intercalaire ;
- les figures 2A à 2E et 3A à 3E illustrent les étapes successives de deux variantes du procédé conforme à l'invention.

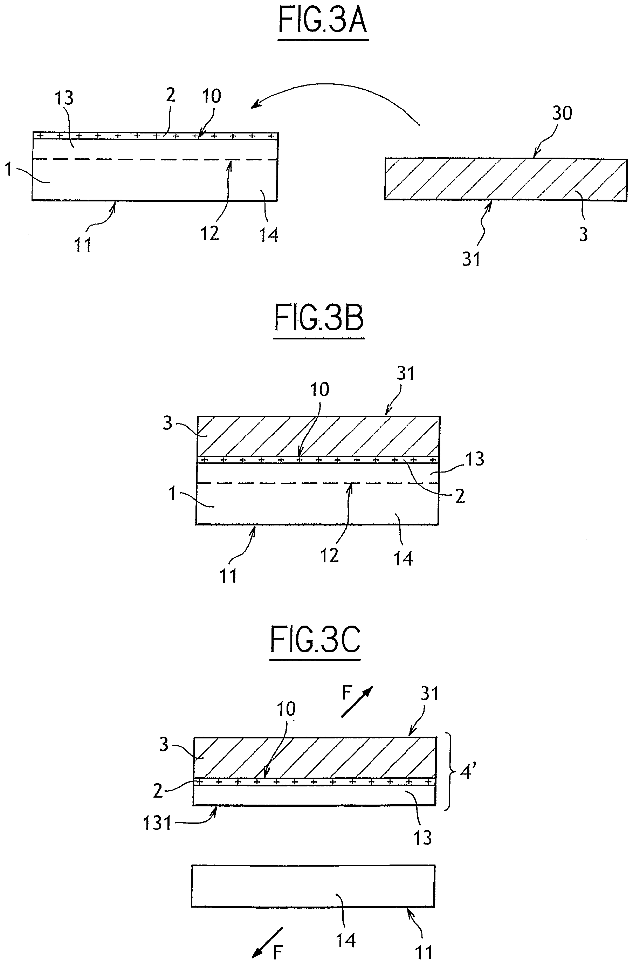

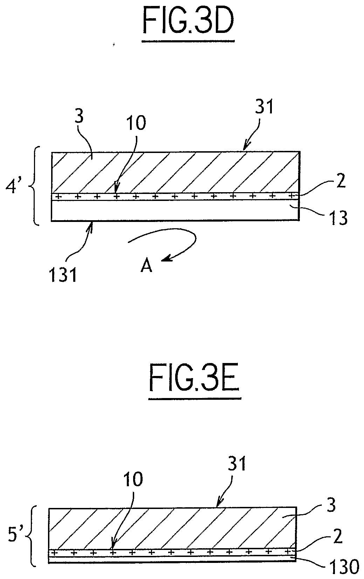

Les figures 2A à 2E et 3A à 3E sont des schémas sur lesquels les différentes couches et leurs épaisseurs ne sont pas représentées à l'échelle et ont pour certaines été volontairement agrandies à des fins de clarification.

En se reportant à la figure 2A, on peut voir un substrat source 1 qui présente intérieurement une zone de fragilisation 12 délimitant deux parties, à savoir une couche utile 13 à transférer et un reste 14 ou partie arrière de ce substrat source.

Il présente une face 10, dite "face avant" destinée à venir au contact d'un substrat support 3 et située du côté de la couche utile 13 à transférer et une face opposée 11, dite "face arrière".

La zone de fragilisation 12 peut être obtenue par implantation d'espèces atomiques.

Par l'expression "implantation d'espèces atomiques", on entend tout bombardement d'espèces atomiques, moléculaires ou ioniques, susceptible d'introduire ces espèces dans un matériau, avec un maximum de concentration de ces espèces situé à une profondeur déterminée par rapport à la surface bombardée 10. Les espèces atomiques moléculaires ou ioniques sont introduites dans le matériau avec une énergie également distribuée autour d'un maximum.

L'implantation des espèces atomiques dans ledit substrat source 1 peut être réalisée par exemple, grâce à un implanteur par faisceau d'ions ou un implanteur par immersion dans un plasma.

De préférence, cette implantation est réalisée par bombardement ionique. De préférence, l'espèce ionique implantée est de l'hydrogène. D'autres espèces ioniques peuvent avantageusement être utilisées seules ou en combinaison avec l'hydrogène, telles les gaz rares (l'hélium par exemple).

Cette implantation a pour effet de créer dans le volume du substrat source 1 et à une profondeur moyenne de pénétration des ions, la zone de fragilisation 12, sensiblement parallèlement au plan de la face avant 10.
On pourra par exemple se référer à la littérature concernant le procédé connu sous la marque déposée "mart Cut".
La zone de fragilisation 12 peut également être constituée par une couche poreuse obtenue, par exemple, par le procédé décrit dans le document EP-0 849 788.
La couche utile 13 à transférer peut également être une couche dont la face avant 10 présente des cavités obtenues par gravure, une telle couche étant connue de l'homme du métier sous la dénomination de "couche à motifs suspendus". Une telle couche est utilisée dans la réalisation de composants mécaniques micro électriques connus sous l'acronyme de "MEMS", de l'expression anglaise "Micro Electronical Mechanical Systems".
Le substrat support 3 a un rôle de support mécanique et présente à ce titre une épaisseur de plusieurs centaines de micromètres (typiquement environ 300μm).
Il présente une face avant 30 destinée à venir au contact de la face avant 10 du substrat source 1 et une face opposée 31, dite "face arrière".
Le substrat source 1 et le substrat support 3 peuvent être constitués de n'importe quel matériau, notamment ceux utilisés couramment dans les applications des domaines de l'électronique, l'optoélectronique ou l'optique, tels que les matériaux semi-conducteurs.
A titre d'exemple illustratif, on peut utiliser comme matériau constitutif du substrat support 3 et du substrat source 1, le silicium, matériau fréquemment utilisé dans les applications précitées, le carbure de silicium le germanium, le silicium germanium, les composés IV-IV et les composés III-V ou une combinaison de ces matériaux, c'est-à-dire un substrat multi-couches comprenant au moins deux couches de matériaux choisis parmi ceux précités.
Les composés IV-IV, sont des composés dont les deux éléments appartiennent à la colonne IVa de la classification périodique des éléments. Les composés III-V sont des composés dont l'un des éléments appartient à la colonne IIIa de la classification périodique et l'autre à la colonne Va, tels que par exemple, le nitrure de gallium (GaN), l'arséniure de gallium (AsGa) ou le phosphure d'indium (InP).
Quel que soit le mode d'obtention de la zone de fragilisation 12, celle-ci sera formée de façon que la couche utile 13 à transférer présente une épaisseur très importante par rapport à l'épaisseur de la couche finale que l'on souhaite obtenir sur le substrat support 3.
Les caractéristiques concernant l'épaisseur de cette couche à transférer 13 seront décrites ultérieurement.
Comme représenté sur la figure 2B, la face avant 30 du substrat support 3 est ensuite collée par adhésion moléculaire contre la face avant 10 du substrat source 1.

De façon avantageuse, on effectue alors un traitement de recuit thermique de l'empilement ayant pour fonction de renforcer l'interface de collage entre la face avant 10 du substrat source 1 et la face avant 30 du substrat support 3. Ce traitement thermique est effectué à une température appropriée en fonction de la nature chimique des matériaux en contact.

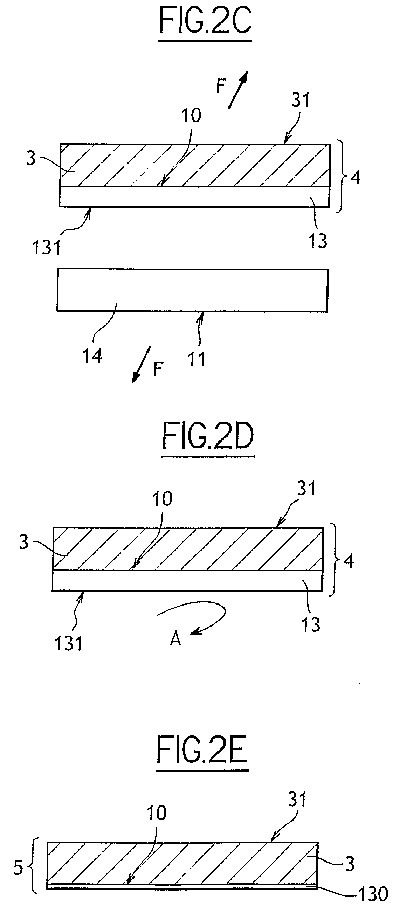

Comme représenté sur la figure 2C, on procède ensuite au détachement du substrat support 3 et de la couche à transférer 13, du reste 14 du substrat source 1, le long de la zone de fragilisation 12.

Ce détachement est effectué par exemple par application de contraintes d'origine mécanique qui sont généralement des contraintes de traction et/ou de flexion et/ou de cisaillement.

Ces contraintes peuvent être appliquées par exemple, par un bâti de traction, par une ou plusieurs lames introduite(s) sur le côté de l'empilement de couches précité, au niveau de la zone de fragilisation 12 ou par un jet de fluide (liquide ou gaz), appliqué latéralement au niveau de cette même zone de fragilisation.

L'application de ces contraintes d'origine mécanique permet de favoriser la propagation d'une fissure au niveau de la zone de fragilisation 12.

Ce détachement peut également être effectué par application de contraintes d'origine thermique.

Les contraintes d'origine mécanique et d'origine thermique peuvent également être combinées.

On obtient ainsi une structure intermédiaire référencée 4 comprenant le substrat support 3 et la couche utile 13 qui est alors dénommée "couche transférée".

Comme illustré sur la figure 2D, on procède ensuite à une étape d'amincissement de la couche utile 13 transférée (flèche A), jusqu'à obtenir une couche ultramince, référencée 130 (voir figure 2E).

La structure finale obtenue, référencée 5, comprend le support 3 et la couche ultramince 130.

L'amincissement peut être effectué par l'une ou l'autre ou plusieurs des techniques suivantes choisies par exemple parmi le polissage mécanico-chimique (CMP), le recuit dans une atmosphère contenant de l'hydrogène et/ou de l'argon, l'oxydation sacrificielle, la gravure chimique sèche ou humide.

Le polissage mécanico-chimique est une technique combinant un polissage mécanique effectué par le passage d'une tête de polissage rotative sur la surface libre 131 de la couche transférée 13 et un polissage chimique mis en oeuvre par distribution d'un abrasif sous forme pâteuse ou liquide, tel qu'une silice colloïdale, entre la surface de cette tête de polissage et la surface 131 à polir.

Le recuit dans une atmosphère contenant de l'hydrogène et/ou de l'argon consiste à faire recuire la structure intermédiaire 4 dans une telle atmosphère, à une température d'environ 1050°C à environ 1350°C, pendant quelques dizaines de seconde à quelques dizaines de minutes. Ce recuit permet un réarrangement des atomes de la surface 131 qui se déplacent jusqu'à atteindre un niveau énergétique stable conduisant à un lissage de la surface 131 et donc à une diminution de l'épaisseur (amincissement) de la couche 13.

L'oxydation sacrificielle consiste à chauffer la surface libre 131 sous une atmosphère oxydante jusqu'à former une couche d'oxyde que l'on élimine et à répéter plusieurs fois cette opération jusqu'à atteindre l'épaisseur souhaitée pour la couche ultramince 130.

Enfin, les opérations de gravure chimique comprennent la gravure humide effectuée dans un bain de produits chimiques ou la gravure sèche effectuée dans un plasma de gaz qui grave la couche transférée 13. La gravure sèche peut également être effectuée par bombardement ionique, par exemple d'argon, qui par un effet mécanique balistique diminue l'épaisseur de la couche 13, jusqu'à l'obtention de la couche ultramince 130.

L'épaisseur finale de la couche ultramince 130 obtenue à l'issue de l'étape d'amincissement est inférieure ou égale à 100 nanomètres (100 nm), voire même inférieure ou égale à 50 nanomètres (50 nm).

Le traitement de recuit thermique décrit précédemment et visant à renforcer l'interface de collage entre la face avant 10 du substrat source 1 et la face avant 30 du support 3 peut également être effectué pendant l'étape de détachement ou après celle-ci, mais toujours avant l'étape d'amincissement. Ces traitements thermiques de recuit peuvent également être répétés plusieurs fois entre le collage et l'amincissement.

On notera que lorsque le recuit thermique est effectué pendant l'étape de détachement, il est possible d'effectuer un unique traitement thermique selon une courbe de température croissante.

Ainsi par exemple, lorsque le substrat source 1 est du silicium, le détachement le long de la zone de fragilisation 12 se réalise à environ 500°C, puis lorsque l'on atteint une température d'au moins 1000°C que l'on maintient pendant quelques heures, se produit le renforcement de l'interface de collage.

Conformément à l'invention et contrairement à ce qui est réalisé actuellement dans l'état de la technique, le procédé d'obtention d'une couche ultramince 130 consiste à passer par une étape intermédiaire (obtention d'une structure intermédiaire 4) au cours de laquelle on transfert une couche utile 13 d'une épaisseur notablement plus grande que celle de la couche ultramince 130 que l'on souhaite obtenir à la fin du procédé.

L'expression "notablement plus grande" signifie que la couche à transférer 13 présente une épaisseur suffisante pour supporter les différents traitements thermiques précités de détachement ou de renforcement de son interface de collage avec le substrat support 3, et ce, sans que cela entraîne la formation de défauts ou de cloques au niveau de cette interface. L'épaisseur de la couche à transférer 13 est au moins trois fois celle de la couche ultramince 130 de cette couche 13 est supérieure ou égale à 300 nanomètres alors que par comparaison, la couche ultramince 130 est inférieure ou égale à 100 nanomètres, voire même inférieure ou égale à 50 nanomètres.

Les figures 3A à 3E illustrent une variante de réalisation du procédé décrit précédemment conjointement avec les figures 2A à 2E.

Selon cette variante, une couche intercalaire 2 est intercalée entre la face avant 10 du substrat source 1 et la face avant 30 du substrat support 3 (voir figure 3B).

Comme on peut le voir sur la figure 3A, cette couche intercalaire 2 est formée avant l'étape de collage par adhésion moléculaire, de préférence sur la face avant 10 du substrat source 1. Toutefois, elle pourrait également être formée sur la face avant 30 du substrat support 3 ou sur ces deux faces avant 10 et 30.

Cette couche intercalaire 2 peut être obtenue par exemple par une technique de dépôt chimique en phase vapeur connue sous l'acronyme CVD, de la terminologie anglaise "Chemical Vapor Deposition" ou par des techniques d'épitaxie, à savoir par exemple l'épitaxie en phase vapeur d'organo-métallique ("MOCVD" de l'expression anglaise "Metal Organic Chemical Vapor Déposition"), l'épitaxie par jet moléculaire ("MBE" de l'expression anglaise "Molecular Beam Epitaxy" ou l'épitaxie en phase de vapeurs d'hydrure ("HVPE" de l'expression anglaise "Hydride Vapor Phase Epitaxy").

Lorsque cette couche intercalaire 2 est un oxyde, elle peut également être obtenue par oxydation du substrat massif 1.

Lorsque la zone de fragilisation 12 est obtenue par implantation d'espèce atomique, le dépôt de la couche intercalaire 2 est effectué de préférence avant l'implantation. L'élévation importante de la température liée au procédé de dépôt est en effet susceptible d'être préjudiciable à la couche de fragilisation 12.

Par contre, lorsque la zone de fragilisation 12 est une couche poreuse, la couche intercalaire 2 est déposée après la formation de cette zone poreuse et de la couche utile 13 à transférer, cette dernière étant généralement obtenue par une reprise d'épitaxie.

Cette couche intercalaire 2 peut être constituée par exemple d'une couche d'un matériau isolant, notamment de l'oxyde de silicium ($SIO_2$), du nitrure de silicium ($SI_3N_4$), du diamant, un matériau isolant à forte permittivité ou d'une combinaison de ces matériaux, par exemple l'oxynitrure de silicium. Cette couche intercalaire 2 peut également être composée de plusieurs couches des différents matériaux précités, (matériau multi-couches).

Les autres étapes du procédé sont identiques à celles qui viennent d'être décrites et ne seront donc pas reprises en détail. On notera qu'après l'étape de détachement représentée sur la figure 3C, on obtient une structure intermédiaire 4' comprenant le support 3, la couche intercalaire 2 et la couche reportée 13.

On obtient à l'issue de l'opération d'amincissement, un substrat support 3 supportant successivement la couche intercalaire 2 puis la couche ultramince 130 et formant une structure finale référencée 5'.

De préférence, la couche intercalaire 2 est de faible épaisseur, c'est à dire inférieure ou égale à 50 nm (50 nanomètres).

Grâce au procédé selon l'invention, on peut ainsi obtenir un substrat de type SOI dont la couche intercalaire d'oxyde de silicium et la couche de silicium superficielle présentent toutes deux des épaisseurs inférieures à 50 nm, ce qui n'était pas possible jusqu'à présent.

Deux exemples particuliers de réalisation du procédé conforme à l'invention vont maintenant être décrits.

Exemple 1 :

On procède à l'oxydation thermique d'un substrat source 1 en silicium massif de façon à recouvrir celui-ci d'une couche intercalaire 2 d'oxyde de silicium (SiO2) de 50 nanomètres (50 nm) d'épaisseur.

On forme ensuite la zone de fragilisation 12 par implantation d'ions hydrogène $H^+$ selon une dose d'implantation de $8.10^{16}$ $H^+/cm^2$ et une énergie d'implantation de 210 keV, de façon à obtenir une couche à transférer 13 d'une épaisseur de 1,9 $\mu$m (1,9 micromètres).

On procède alors au collage par adhésion moléculaire d'un substrat support 3 en silicium massif sur ladite couche d'oxyde 2.

On réalise ensuite le détachement du reste 14 du substrat source 1 par un traitement thermique inférieur à 500°C et le renforcement de l'interface de collage par un traitement thermique à plus de 1000°C.

On réalise enfin l'amincissement par polissage et oxydation sacrificielle, jusqu'à obtenir une structure finale 5' dont la couche de silicium ultramince 130 est d'une épaisseur de 50 nm, voire même de 20 nm si cette étape d'amincissement est poursuivie.

Exemple 2 :

On procède comme dans l'exemple 1, si ce n'est que la couche d'oxyde de silicium 2 fait 20 nanomètres d'épaisseur.

Exemple 3 :

On procède comme dans l'exemple 1 mais avec une dose d'implantation de $7.10^{16}$ $H^+/cm^2$ et une énergie d'implantation de 160 Kev, de sorte que la couche à transférer 13 présente une épaisseur de 1,5 $\mu$m (1,5 micromètres).

Exemple 4 :

On procède comme dans l'exemple 3 mais avec une couche d'oxyde de silicium 2 d'une épaisseur de 20 nanomètres.

**Revendications**

1. Procédé d'obtention d'une structure (5, 5') comprenant au moins un substrat support (3) et une couche ultramince (130) issue d'un substrat source (1) notamment en matériau semi-conducteur, pour des applications dans les domaines de l'électronique, l'optoélectronique ou l'optique, ce procédé comprenant les étapes successives consistant à :

   - a) coller par adhésion moléculaire un substrat support (3) sur l'une des faces (10), dite "face avant", d'un substrat source (1) qui présente intérieurement une zone de fragilisation (12) délimitant avec ladite face avant (10), une couche utile (13) dite "couche à transférer",
   - b) détacher ledit substrat support (3) et ladite couche utile (13) à transférer, du reste (14) du substrat source (1), le long de ladite zone de fragilisation (12), de façon à obtenir une structure intermédiaire (4, 4') comprenant au moins ladite couche utile (13) transférée et ledit substrat support (3),
   - c) procéder à l'amincissement de ladite couche utile (13) transférée jusqu'à obtenir ladite couche ultra mince (130),

   ce procédé étant **caractérisé en ce que** la couche utile (13) à transférer de la structure intermédiaire (4,4') présente une épaisseur au moins trois fois supérieure ou égale à celle de ladite couche ultramince (130) obtenue à l'issue de l'étape c) d'amincissement et **en ce que** l'épaisseur de ladite couche ultramince (130) est inférieure ou égale à 100 nanomètres et **en ce que** l'épaisseur de la couche utile (13) à transférer de la structure intermédiaire (4, 4') est supérieure ou égale à 300 nanomètres.

2. Procédé selon la revendication 1 d'obtention d'une structure (5') comprenant un substrat support (3), une couche ultra mince (130) issue d'un substrat source (1) notamment en matériau semi-conducteur et une couche intercalaire (2) insérée entre ledit substrat support (3) et cette couche ultra mince (130), **caractérisé en ce qu'**avant l'étape a) de collage par adhésion moléculaire, une couche intercalaire (2) est formée sur la face avant (10) du substrat source (1) ou sur la face avant (30) du substrat (3) ou sur les deux.

3. Procédé selon l'une des revendications précédentes **caractérisé en ce que** l'épaisseur de la couche ultra mince (130) est inférieure ou égale à 50 nanomètres.

4. Procédé la revendication 2 ou 3, **caractérisé en ce que** l'épaisseur de ladite couche intercalaire (2) est inférieure ou égale à 50 nanomètres.

5. Procédé selon l'une quelconque des revendications 2 à 4, **caractérisé en ce que** ladite couche intercalaire (2) est une couche de matériau isolant.

6. Procédé selon la revendication 5, **caractérisé en ce que** la couche intercalaire (2) est une couche d'un matériau choisi parmi l'oxyde de silicium, le nitrure de silicium, les matériaux isolants à forte permittivité, le diamant et les combinaisons de ces matériaux.

7. Procédé selon l'une quelconque des revendications précédentes, **caractérisé en ce que** l'amincissement est réalisé par au moins l'une des techniques suivantes parmi le polissage mécanico-chimique, le recuit sous une atmosphère contenant de l'hydrogène ou de l'argon ou un mélange des deux, l'oxydation sacrificielle et la gravure chimique.

8. Procédé selon l'une quelconque des revendications précédentes, **caractérisé en ce que** l'on procède à un traitement de recuit thermique après l'étape a) de collage et avant l'étape c) d'amincissement.

9. Procédé selon la revendication 8, **caractérisé en ce que** le traitement de recuit thermique est effectué pendant l'étape b) de détachement.

10. Procédé selon la revendication 8, **caractérisé en ce que** le traitement de recuit thermique est effectué avant l'étape b) de détachement.

11. Procédé selon l'une quelconque des revendications précédentes, **caractérisé en ce que** la zone de fragilisation (12) est obtenue par implantation d'espèces atomiques.

12. Procédé selon l'une quelconque des revendications 1 à 10, **caractérisé en ce que** la zone de fragilisation (12) est une couche poreuse.

13. Procédé selon l'une quelconque des revendications précédentes, **caractérisé en ce que** le détachement de l'étape b) comprend l'application de contraintes mécaniques et/ou thermiques.

14. Procédé selon l'une quelconque des revendications précédentes, **caractérisé en ce que** la couche utile (13) transférée est une couche comportant des motifs suspendus.

15. Procédé selon l'une quelconque des revendications précédentes, **caractérisé en ce que** le substrat source (1) est réalisé dans un matériau choisi parmi le silicium, le carbure de silicium, le germanium, le silicium germanium, les composés IV-IV et les composés III-V ou une combinaison de ces matériaux.

16. Procédé selon l'une quelconque des revendications précédentes, **caractérisé en ce que** le substrat support (3) est réalisé dans un matériau choisi parmi le silicium, le carbure de silicium, le germanium, le silicium germanium, les composés IV-IV et les composés III-V ou une combinaison de ces matériaux.

**Patentansprüche**

1. Verfahren zur Herstellung einer Struktur (5, 5'), umfassend mindestens ein Trägersubstrat (3) und eine ultradünne Schicht (130), hervorgegangen aus einem Quellsubstrat (1), insbesondere aus Halbleitermaterial für Anwendungen auf den Gebieten der Elektronik, der Optoelektronik oder der Optik, wobei dieses Verfahren die aufeinanderfolgenden Schritte umfasst, die darin bestehen:

   - a) Kleben, durch molekulare Adhäsion, eines Trägersubstrats (3) auf eine der Seiten (10), als "Vorderseite" bezeichnet, eines Quellsubstrats (1), das innerlich eine Schwächungszone (12) aufweist, die mit der Vorderseite (10) eine Nutzschicht (13), als zu "übertragende Schicht" bezeichnet, begrenzt
   - b) Lösen des Trägersubstrats (3) und der zu übertragenden Nutzschicht (13) vom Rest (14) des Quellsubstrats (1) entlang der Schwächungszone (12), um eine Übergangsstruktur (4, 4') zu erhalten, die mindestens die übertragene Nutzschicht (13) und das Trägersubstrat (3) umfasst,
   - c) Durchführen der Verschlankung der übertragenen Nutzschicht (13) bis zum Erhalt der ultradünnen Schicht (130),

   wobei dieses Verfahren **dadurch gekennzeichnet ist, dass** die zu übertragende Nutzschicht (13) der Übergangsstruktur (4, 4') eine Dicke aufweist, die mindestens dreimal größer oder gleich der der ultradünnen Schicht (130) ist, die nach Abschluss des Verschlankungsschritts c) erhalten wird und dass die Dicke der ultradünnen Schicht (130) kleiner oder gleich 100 Nanometer ist und dass die Dicke der zu übertragenden Nutzschicht (13) der Übergangsstruktur (4, 4') größer oder gleich 300 Nanometer ist.

2. Verfahren nach Anspruch 1 zur Herstellung einer Struktur (5'), umfassend ein Trägersubstrat (3), eine ultradünne Schicht (130), hervorgegangen aus einem Quellsubstrat (1) insbesondere aus Halbleitermaterial, und eine Zwischenschicht (2), eingesetzt zwischen dem Trägersubstrat (3) und dieser ultradünnen Schicht (130), **dadurch gekennzeichnet, dass** vor dem Schritt a) des Klebens durch molekulare Adhäsion eine Zwischenschicht (2) auf der Vorderseite (10) des Quellsubstrats (1) oder auf der Vorderseite (30) des Substrats (3) oder auf beiden gebildet wird.

3. Verfahren nach einem der vorangehenden Ansprüche, **dadurch gekennzeichnet, dass** die Dicke der ultradünnen Schicht (130) kleiner oder gleich 50 Nanometer ist.

4. Verfahren nach Anspruch 2 oder 3, **dadurch gekennzeichnet, dass** die Dicke der Zwischenschicht (2) kleiner oder gleich 50 Nanometer ist.

5. Verfahren nach einem der Ansprüche 2 bis 4, **dadurch gekennzeichnet, dass** die Zwischenschicht (2) eine Schicht aus Isolationsmaterial ist.

6. Verfahren nach Anspruch 5, **dadurch gekennzeichnet, dass** die Zwischenschicht (2) eine Schicht eines Materials ist, das aus dem Siliziumoxid, dem Siliziumnitrid, den Isolationsmaterialien mit hoher Permittivität, dem Diamant und den Kombinationen dieser Materialien ausgewählt ist.

7. Verfahren nach einem der vorangehenden Ansprüche, **dadurch gekennzeichnet, dass** die Verschlankung mittels mindestens einer der folgenden Techniken mechanisch-chemische Politur, Tempern in einer Atmosphäre, die Wasserstoff oder Argon oder ein Gemisch beider enthält, Opferoxidation und chemische Gravur durchgeführt wird.

8. Verfahren nach einem der vorangehenden Ansprüche, **dadurch gekennzeichnet, dass** das thermische Tempern nach dem Klebeschritt a) und vor dem Verschlankungsschritt c) durchgeführt wird.

9. Verfahren nach Anspruch 8, **dadurch gekennzeichnet, dass** die thermische Temperbehandlung während des Löseschritts b) durchgeführt wird.

10. Verfahren nach Anspruch 8, **dadurch gekennzeichnet, dass** die thermische Temperbehandlung vor dem Löseschritt b) durchgeführt wird.

11. Verfahren nach einem der vorangehenden Ansprüche, **dadurch gekennzeichnet, dass** die Schwächungszone (12) durch Implantation von Atomspezies durchgeführt wird.

12. Verfahren nach einem der Ansprüche 1 bis 10, **dadurch gekennzeichnet, dass** die Schwächungszone (12) eine poröse Schicht ist.

13. Verfahren nach einem der vorangehenden Ansprüche, **dadurch gekennzeichnet, dass** das Lösen von Schritt b) die Anwendung mechanischer und/oder thermischer Beanspruchungen umfasst.

**14.** Verfahren nach einem der vorangehenden Ansprüche, **dadurch gekennzeichnet, dass** die übertragene Nutzschicht (13) eine Schicht ist, die Schwebemotive aufweist.

**15.** Verfahren nach einem der vorangehenden Ansprüche, **dadurch gekennzeichnet, dass** das Quellsubstrat (1) aus einem Material hergestellt ist, das aus dem Silizium, dem Siliciumcarbid, dem Germanium, dem Siliciumgermanium, den Verbindungen IV-IV und den Verbindungen III-V oder einer Kombination dieser Materialien ausgewählt ist.

**16.** Verfahren nach einem der vorangehenden Ansprüche, **dadurch gekennzeichnet, dass** das Trägersubstrat (3) aus einem Material hergestellt ist, das aus dem Silizium, dem Siliziumcarbid, dem Germanium, den Siliziumgermanium, den Verbindungen IV-IV und den Verbindungen III-V oder einer Kombination dieser Materialien ausgewählt ist.

**Claims**

**1.** A method of producing a structure (5, 5') comprising at least one support substrate (3) and an ultrathin layer (130) deriving from a source substrate (1), in particular made of a semiconductor material, for applications in the fields of electronics, optoelectronics or optics, said method comprising the following steps:

    a) bonding, by molecular bonding, a support substrate (3) onto one of the faces termed the "front face" (10) of a source substrate (1), having therein a zone of weakness (12), defining with said front face (10) a useful layer (13) termed the "layer to be transferred",
    b) detaching said support substrate (3) and said useful layer (13) to be transferred from the remainder (14) of the source substrate (1), along said zone of weakness (12), to obtain an intermediate structure (4,4') comprising at least said transferred useful layer (13) and said support substrate (3);
    c) thinning said transferred useful layer (13) to obtain said ultrathin layer (130),

this method being **characterized in that** the useful layer (13) to be transferred of the intermediate structure (4, 4') is at least three times thicker than said ultrathin layer (130) obtained from the thinning step c), **in that** the thickness of the ultrathin layer (130) is 100 nanometers or less and **in that** the thickness of said useful layer (13) to be transferred of the intermediate structure (4, 4') is 300 nanometers or more.

**2.** A method according to claim 1 for obtaining a structure (5') comprising a support substrate (3), an ultrathin layer (130) deriving from a source substrate (1), in particular formed from a semiconductor material, and an interposed layer (2) inserted between said support substrate (3) and said ultrathin layer (130), **characterized in that** before step a) of molecular bonding, an interposed layer (2) is formed on the front face (10) of the source substrate (1) or on the front face (30) of the substrate (3) or on both.

**3.** A method according to one of the preceding claim, **characterized in that** the thickness of said ultrathin layer (130) is 50 nanometers or less.

**4.** A method according to claim 2 or claim 3, **characterized in that** the thickness of said interposed layer (2) is 50 nanometers or less.

**5.** A method according to any one of claims 2 to 4, **characterized in that** said interposed layer (2) is a layer of insulating material.

**6.** A method according to claim 5, **characterized in that** the interposed layer (2) is a layer of a material selected from silicon oxide, silicon nitride, high permittivity insulating materials, diamond, and combinations of said materials.

**7.** A method according to any one of the preceding claims, **characterized in that** thinning is carried out using at least one of the following techniques: chemical-mechanical polishing, annealing in an atmosphere containing hydrogen, argon or a mixture thereof; sacrificial oxidation; and chemical etching.

**8.** A method according to any one of the preceding claims, **characterized in that** a heat annealing treatment is carried out after bonding step a) and before thinning step c).

**9.** A method according to claim 8, **characterized in that** the heat annealing treatment is carried out during detachment step b).

**10.** A method according to claim 8, **characterized in that** the heat annealing treatment is carried out before detachment step b).

**11.** A method according to any one of the preceding claims, **characterized in that** the zone of weakness (12) is obtained by atomic species implantation.

**12.** A method according to any one of claims 1 to 10, **characterized in that** the zone of weakness (12) is a porous layer.

**13.** A method according to any one of the preceding claims, **characterized in that** detachment step b) comprises applying mechanical and/or thermal stresses.

14. A method according to any one of the preceding claims, **characterized in that** the transferred useful layer (13) is a layer comprising suspended motifs.

15. A method according to any one of the preceding claims, **characterized in that** the source substrate (1) is formed from a material selected from silicon, silicon carbide, germanium, silicon germanium, IV-IV compounds, and III-V compounds, or a combination of said materials.

16. A method according to any one of the preceding claims, **characterized in that** the support substrate (3) is formed from a material selected from silicon, silicon carbide, germanium, silicon germanium, IV-IV compounds, and III-V compounds, or a combination of said materials.

## FIG.1

## FIG.2A

## FIG.2B

## FIG.2C

## FIG.2D

## FIG.2E

## FIG.3A

## FIG.3B

## FIG.3C

## FIG.3D

## FIG.3E

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 0048278 A

- EP 0849788 A

**Littérature non-brevet citée dans la description**

- **AARON MAND.** Value-Added Wafers Push Chips Ahead. *Semiconductor International,* Novembre 2002
- **M.BRUEL.** Silicon on insulator material technology. *Electron Letter,* 1995, vol. 31, 1201

- **Q.-Y. TONG ; G. CHA ; R. GAFITEAU ; U. GÖSELE.** Low temperature wafer direct bonding. *J. Microelectromech Syst.,* 1994, vol. 3, 29